# EUROPEAN PATENT APPLICATION

(11) **EP 4 322 724 A1**
(43) Date of publication of application: **14.02.2024**
(21) Application number: 23190970.6
(22) Date of filing: 10.08.2023
(51) Int. Cl.: H10K 59/121, H10K 59/126, H10K 77/10

(54) **DISPLAY PANEL AND METHOD OF MANUFACTURING THE SAME**

(30) Priority: 10.08.2022 KR 20220099769
(71) Applicant: Samsung Display Co., Ltd., Gyeonggi-Do (KR)
(72) Inventor: LIM, Sanghyung, Yongin-si (KR)
(74) Representative: Marks & Clerk LLP

(57) **Abstract**

A display panel includes a base layer including an upper surface and a lower surface opposite to the upper surface, partially removed from the upper surface in a thickness direction, and including a trench defined by a side surface connected to the upper surface and a bottom surface connected to the side surface, a light blocking pattern at least partially overlapping the trench and disposed on the base layer, and a pixel including a first transistor including a semiconductor pattern at least partially overlapping the trench, a first electrode, a second electrode, and a gate, and a light emitting element connected to the first transistor, and at least a portion of the semiconductor pattern is parallel to the side surface.

## Description

### BACKGROUND OF THE INVENTION

The inventive concept relates to a display panel and a method of manufacturing the same, and particularly relates to a display panel in which a design of a semiconductor pattern included in a transistor is easily changed and a method of manufacturing the same.

A display panel includes a plurality of pixels and a driving circuit (e.g., a scan driving circuit and a data driving circuit) for controlling the plurality of pixels. Each of the plurality of pixels includes a display element and a pixel driving circuit for controlling the display element. The pixel driving circuit may include a plurality of transistors organically connected to each other.

The scan driving circuit and/or the data driving circuit may be formed through the same process as the plurality of pixels. The scan driving circuit and/or the data driving circuit may include a plurality of transistors organically connected to each other.

### SUMMARY

An embodiment of the inventive concept provides a high-resolution display panel and a method manufacturing the same.

According to an embodiment of the inventive concept, a display panel may include a base layer including an upper surface and a lower surface opposite to the upper surface, partially removed from the upper surface in a thickness direction, and including a trench defined by a side surface connected to the upper surface and a bottom surface connected to the side surface, a light blocking pattern at least partially overlapping the trench and disposed on the base layer, and a pixel including a first transistor including a semiconductor pattern at least partially overlapping the trench, a first electrode, a second electrode, and a gate, and a light emitting element connected to the first transistor, and at least a portion of the semiconductor pattern may be parallel to the side surface.

According to an embodiment of the inventive concept, a display panel may include a base layer including a first region partially removed from an upper surface in a thickness direction and a second region surrounding the first region, a light blocking pattern at least partially overlapping the first region and disposed on the base layer, and a pixel including first to third transistors each including a semiconductor pattern, a first electrode, a second electrode, and a gate, and a light emitting element connected to the first transistor, and one of the semiconductor patterns may overlap the light blocking pattern and may be disposed in the first region and a portion of the second region adjacent to the first region.

According to an embodiment of the inventive concept, a method of manufacturing a display panel may include forming a trench by removing a portion from an upper surface of a base layer in a thickness direction, forming a light blocking pattern at least partially overlapping the trench and disposed on the base layer, forming a first insulating layer on the base layer, forming a semiconductor pattern at least partially overlapping the trench and disposed on the first insulating layer, forming a second insulating layer in which first contact holes exposing a portion of the semiconductor pattern are defined, forming a gate overlapping the semiconductor pattern and disposed on the second insulating layer, and forming first and second electrodes insulated from the gate and connected to the semiconductor pattern through corresponding first contact holes.

At least some of the above features that accord with the invention and other features according to the invention are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1A is a perspective view of a display panel according to an embodiment.
FIG. 1B is a perspective view of a curved display panel according to an embodiment.
FIG. 2 is a cross-sectional view of a display panel according to an embodiment.
FIG. 3 is a plan view of a display panel according to an embodiment.
FIG. 4 is an equivalent circuit diagram of a pixel according to an embodiment of the inventive concept.
FIG. 5A is a plan view illustrating conductive patterns included in a pixel unit in a stacking order according to an embodiment of the inventive concept.
FIG. 5B is a plan view of a base layer according to an embodiment of the inventive concept.
FIGS. 6A to 6E are plan views in which conductive patterns included in a pixel unit is divided by layer in a stacking order according to an embodiment of the inventive concept, respectively.
FIG. 7 is a cross-sectional view taken along line I-I' of FIG. 5A.
FIG. 8A is a cross-sectional view of a display panel according to an embodiment.
FIG. 8B is a cross-sectional view of a display panel according to an embodiment.
FIG. 9 is a cross-sectional view taken along line II-II' of FIG. 5A.
FIG. 10 is a cross-sectional view of another embodiment taken along line II-II' of FIG. 5A.
FIG. 11 is a cross-sectional view of a display panel according to an embodiment.
FIGS. 12A to 12H are cross-sectional views illustrating a method of manufacturing a display panel according to an embodiment.

### DETAILED DESCRIPTION

Herein, when a component (or an area, a layer, a part, etc.) is referred to as being "on," "connected to," or "coupled to" another element, it may be directly on, connected to, or coupled to the other component or intervening components may be present.

Like reference numerals denote like elements. Additionally, in the drawings, thicknesses, proportions, and dimensions of components are exaggerated for effective description of technical content. The term "and/or" includes any and all combinations of one or more of the associated listed items.

It will be understood that, although the terms "first", "second", etc. may be used herein to describe various components, these components should not be limited by these terms. These terms are only used to distinguish one component from another component. For example, a first component discussed below could be termed a second component without departing from the teachings of embodiments. The singular forms are intended to include the plural forms as well, unless the context clearly indicates otherwise.

In addition, terms such as "below," "lower," "above," "upper," and the like are used to describe the relationship of the configurations shown in the drawings. The terms are used as a relative concept and are described with reference to the direction indicated in the drawings.

It should be understood that the terms "comprise", or "include" are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and will not be interpreted in an idealized or overly formal sense, unless expressly so defined herein.

Hereinafter, embodiments of the inventive concept will be described with reference to the drawings.

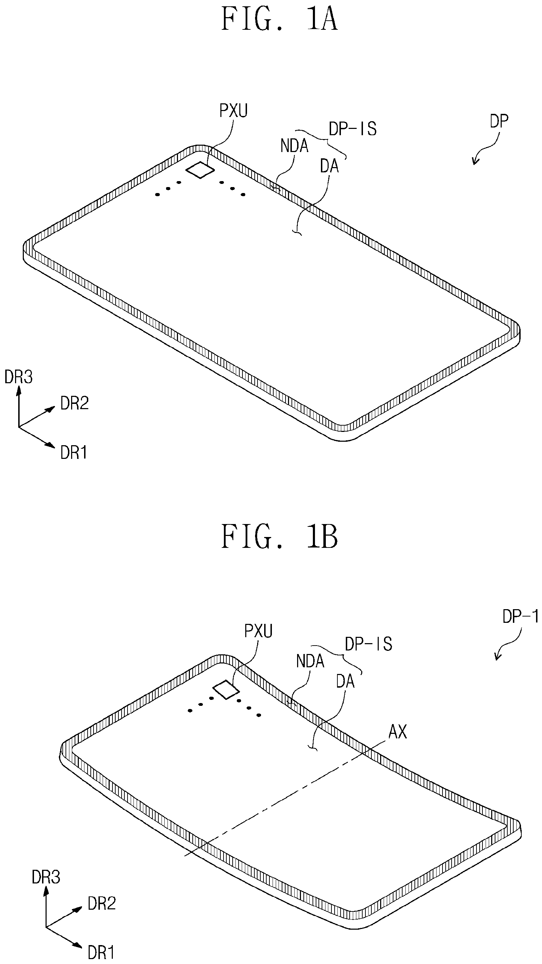

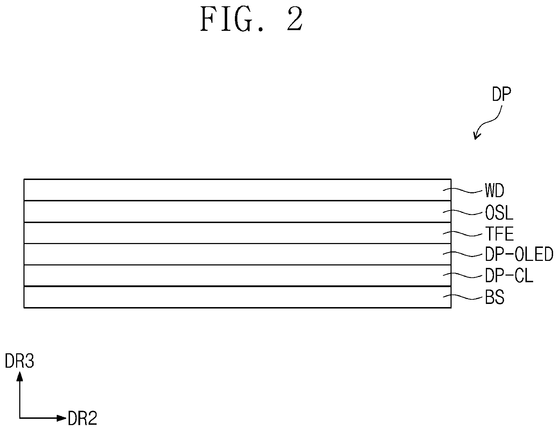

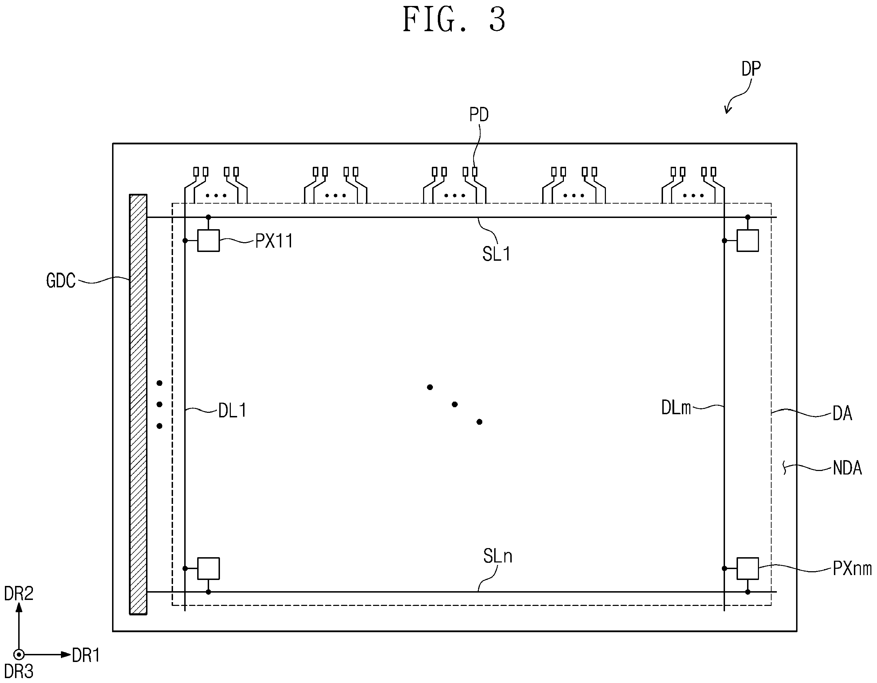

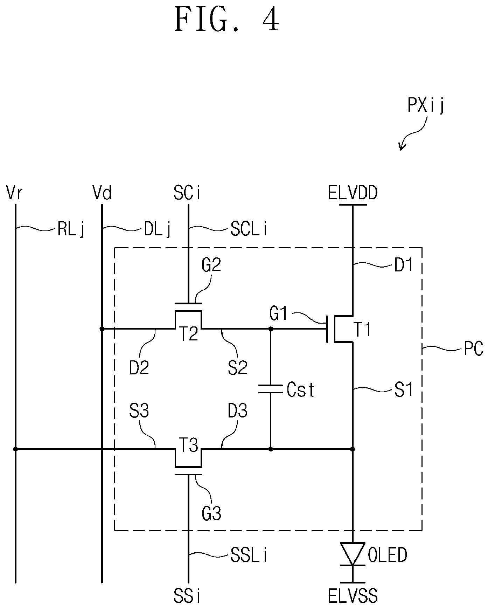

FIG. 1A is a perspective view of a display panel according to an embodiment. FIG. 1B is a perspective view of a curved display panel according to an embodiment. FIG. 2 is a cross-sectional view of a display panel according to an embodiment. FIG. 3 is a plan view of a display panel according to an embodiment. FIG. 4 is an equivalent circuit diagram of a pixel according to an embodiment of the inventive concept.

Each of display panels DP and DP-1 shown in FIGS. 1A and 1B may be a light-emitting display panel, and may be one of a liquid crystal display panel, an electrophoretic display panel, and a microelectromechanical system (MEMS) display panel, an electrowetting display panel, an organic light emitting display panel, an inorganic light emitting display panel, and a quantum-dot display panel, but is not limited thereto.

Referring to FIG. 1A, the display panel DP may display an image through a display surface DP-IS. An upper surface of a member disposed on the uppermost side of the display panel DP may be defined as the display surface DP-IS. According to the inventive concept, an upper surface of a window panel WD shown in FIG. 2 may be defined as the display surface DP-IS of the display panel DP.

The display surface DP-IS may be parallel to a surface defined by a first direction DR1 and a second direction DR2. A third direction DR3 indicates a normal direction of the display surface DP-IS, that is, a thickness direction of the display panel DP. A front surface (or an upper surface) and a rear surface (or a lower surface) of each of layers or components described below are distinguished by the third direction DR3.

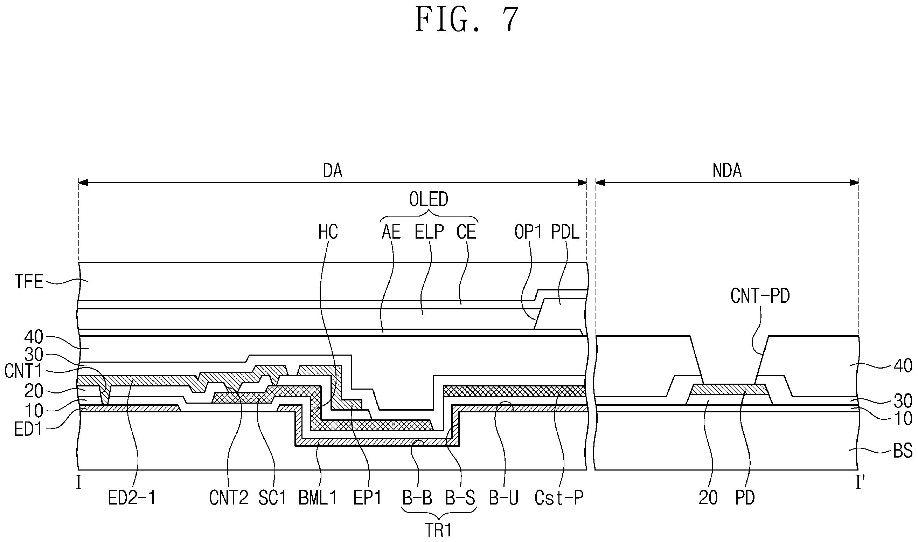

The display surface DP-IS of the display panel DP may include a display area DA and a non-display area NDA. A light emitting pattern ELP (refer to FIG. 7) of a pixel PX (refer to FIG. 3) is disposed in the display area DA, and the light emitting pattern ELP of the pixel PX (refer to FIG. 3) is not disposed in the non-display area NDA. The non-display area NDA is defined along an edge of the display area DA. The non-display area NDA may surround the display area DA. In an embodiment, the non-display area NDA may be omitted or disposed only on one side of the display area DA.

Referring to FIG. 1B, the display panel DP-1 according to an embodiment may be curved in the first direction DR1 with respect to a virtual axis AX extending in the second direction DR2. However, the inventive concept is not limited thereto, and the virtual axis AX may extend in the first direction DR1, or the display panel DP-1 may be curved based on a plurality of axes extending in different directions.

In addition, the display panel DP or DP-1 may be a rollable display panel, a foldable display panel, or a slidable display panel. The display panel DP or DP-1 may have flexible properties, and may be folded or rolled when installed in a display device. Accordingly, the display panel DP or DP-1 may include a curved display surface DP-IS or a three-dimensional display surface DP-IS. The three-dimensional display surface DP-IS may include a plurality of display areas indicating different directions.

FIGS. 1A and 1B illustrate a pixel unit PXU is disposed in the display area DA. The pixel unit PXU may include at least one pixel PX11 to PXnm (refer to FIG. 3) providing different light. For example, the pixel unit PXU may be defined as a group of a pixel providing green light, a pixel providing red light, and a pixel providing blue light. A shape of a light emitting region providing light from the pixels PX to PXnm (refer to FIG. 3) included in the pixel unit PXU may have a stripe or pen-tile^{®} shape, on a plane view.

However, the inventive concept is not limited thereto, and pixels generating different light may be arranged in a triangular shape. For example, a light emitting region of a pixel providing red light and a light emitting region of a pixel providing blue light may be arranged to be spaced apart from each other in the first direction DR1, and a light emitting region of a pixel providing green light may be arranged to be spaced apart from the light emitting region of the pixel providing red light and the light emitting region of the pixel providing blue light in a diagonal direction of each of the first and second directions DR1 and DR2. In addition, the light emitting region of the pixel providing green light may be disposed at an upper end of the pixel unit PXU compared to the light emitting region of the pixel providing red light and the light emitting region of the pixel providing blue light. In this case, the pixel providing the green light may have the largest area of the light emitting region of each of the pixels and the pixel providing the blue light may have the smallest area thereof. However, the inventive concept is not limited thereto, and the areas of the light emitting regions of the pixels providing different light may be the same.

Referring to FIG. 2, the display panel DP according to the inventive concept includes a base layer BS, a circuit element layer DP-CL disposed on the base layer BS, a display element layer DP-OLED, and a thin film encapsulation layer TFE, a light control layer OSL, and a window panel WD. The display panel DP may further include functional layers such as an anti-reflection layer or a refractive index control layer. The circuit element layer DP-CL includes at least a plurality of insulating layers and a circuit element. The insulating layers described below may include an organic layer and/or an inorganic layer.

The base layer BS may be a glass substrate. The base layer BS according to an embodiment may include a synthetic resin film. The synthetic resin film may include a thermosetting resin. In particular, the synthetic resin film may include a polyimide-based resin, and a material thereof is not particularly limited. The synthetic resin film may include at least one of an acrylic-based resin, a methacrylic-based resin, a polyisoprene, a vinyl-based resin, an epoxy-based resin, a urethane-based resin, a cellulose-based resin, a siloxane-based resin, a polyamide-based resin, and a perylene-based resin. In addition, the base layer BS may include a metal substrate or an organic/inorganic composite material substrate.

The circuit element layer DP-CL includes an insulating layer, a semiconductor pattern, and a conductive layer formed through a process such as coating and deposition. Thereafter, the insulating layer, the semiconductor pattern, and the conductive layer may be selectively patterned through photolithography and etching processes. Through these processes, a semiconductor pattern, a conductive pattern, and a signal line are formed. In the inventive concept, conductive patterns disposed on the same layer may be formed through the same process. Accordingly, the conductive patterns disposed on the same layer may be patterned through the same mask.

The thin film encapsulation layer TFE may be disposed on the display element layer DP-OLED to protect a light emitting element OLED (refer to FIG. 7). The thin film encapsulation layer TFE may include inorganic layers and an organic layer disposed between the inorganic layers. The inorganic layers may protect the light emitting element OLED (refer to FIG. 7) from moisture and oxygen, and the organic layer may protect the light emitting element OLED (refer to FIG. 7) from foreign substances such as dust particles.

The light control layer OSL may include color control layers capable of converting optical properties of source light generated by the light emitting element OLED (refer to FIG. 7). The color control layers may include quantum dots, and the light control layer OSL may include color filters that selectively transmit light transmitted through the color control layers.

The window panel WD may be disposed on the display panel DP and may transmit an image provided from the display panel DP to the outside. An upper surface of the window panel WD may be defined as the display surface DP-IS of the display panel DP, and the non-display area NDA of the display surface DP-IS may be formed by a bezel pattern that is disposed below the window panel WD and absorbs light.

The window panel WD may include a base substrate and functional layers disposed on the base substrate. The functional layers may include a protective layer and an anti-fingerprint layer. The base substrate of the window panel WD may be formed of glass, sapphire, or plastic.

FIG. 3 illustrates a planar arrangement of signal lines SL1 to SLn and DL1 to DLm, pixels PX11 to PXnm, and pads PD included in the display panel DP. The signal lines SL1 to SLn and DL1 to DLm may include a plurality of scan lines SL1 to SLn and a plurality of data lines DL1 to DLm.

Each of the pixels PX11 to PXnm is connected to a corresponding one of the plurality of scan lines SL1 to SLn and a corresponding one of the plurality of data lines DL1 to DLm. Each of the pixels PX11 to PXnm may include a pixel driving circuit and a display element. More types of signal lines may be provided in the display panel DP depending on a configuration of the pixel driving circuit of the pixels PX11 to PXnm.

A gate driving circuit GDC may be disposed in the non-display area NDA. The gate driving circuit GDC may be integrated in the display panel DP through an oxide silicon gate driver circuit (OSG) process or an amorphous silicon gate driver circuit (ASG) process.

The pads PD may be disposed in the non-display area NDA. The pads PD may be connected to corresponding pixels PX11 to PXnm, respectively. A circuit board providing a signal to the pixels PX11 to PXnm may be attached to the pads PD. At least one insulating layer among the insulating layers included in the display panel DP may be exposed to form the pads PD.

FIG. 4 illustrates a circuit diagram of one pixel PXij among the pixels PX11 to PXnm in FIG. 3.

Referring to FIG. 4, the pixel PXij may include a pixel circuit PC and a light emitting element OLED. The pixel circuit PC may include a plurality of transistors T1 to T3 and a capacitor Cst.

The plurality of transistors T1 to T3 may be formed through a low temperature polycrystalline silicon (LTPS) process or a low temperature polycrystalline oxide (LTPO) process. Each of first to third transistors T1 to T3 may include one of a silicon semiconductor and an oxide semiconductor. In this case, the oxide semiconductor may include a crystalline or amorphous oxide semiconductor, and the silicon semiconductor may include amorphous silicon and polycrystalline silicon, but is not limited to any one embodiment.

Hereinafter, the first to third transistors T1 to T3 are described as a N-type transistor, but are not limited thereto, and each of the first to third transistors T1 to T3 may be a P-type transistor or an N-type transistor depending on an applied signal. In this case, a source and a drain of the P-type transistor may correspond to a drain and a source of the N-type transistor, respectively.

With demand of a high-definition display panel, transistors included in pixels should also include high-performance transistors to correspond thereto. Accordingly, a display panel including a semiconductor pattern whose design for a width is easy to be changed within the certain area is required.

FIG. 4 illustrates the pixel PXij connected to an i-th scan line SCLi, an i-th sensing line SSLi, a j-th data line DLj, and a j-th reference line RLj.

One pixel PXij illustrated in FIG. 4 may correspond to one of the pixels included in the pixel unit PXU. The pixel circuit PC may include a first transistor T1 (a driving transistor), a second transistor T2 (a switch transistor), a third transistor T3 (a sensing transistor), and a capacitor Cst. However, the pixel circuit PC may further include an additional transistor and an additional capacitor, and is not limited to any one embodiment.

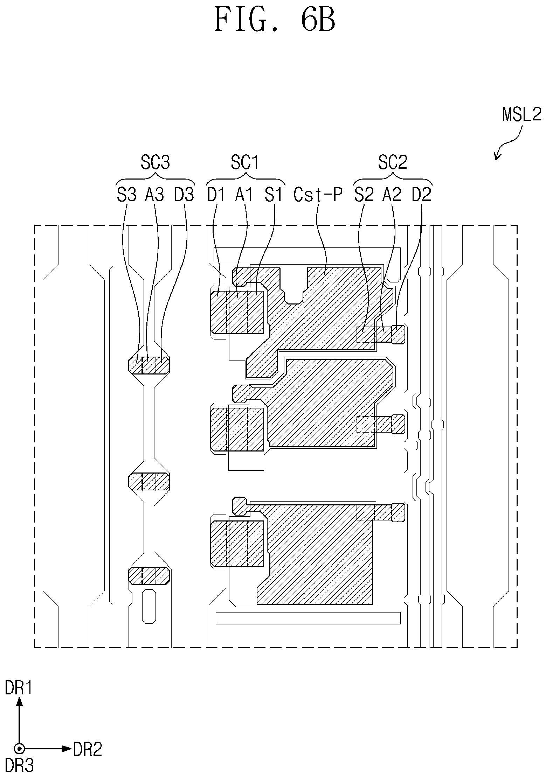

Each of the first to third transistors T1 to T3 includes a source S1, S2, or S3, a drain D1, D2, or D3, a channel region A1, A2, or A3 (refer to FIG. 6B), and a gate G1, G2, or G3.

The light emitting element OLED may be an organic light emitting element or an inorganic light emitting element including an anode and a cathode. The anode of the light emitting element OLED may receive a first voltage ELVDD through the first transistor T1, and the cathode of the light emitting element OLED may receive a second voltage ELVSS. The light emitting element OLED may receive the first voltage ELVDD and the second voltage ELVSS to emit light.

The first transistor T1 may include a drain D1 receiving the first voltage ELVDD, a source S1 connected to the anode of the light emitting element OLED, and a gate G1 connected to the capacitor Cst. The first transistor T1 may control a driving current flowing through the light emitting element OLED from the first voltage ELVDD in response to a voltage value stored in the capacitor Cst.

The second transistor T2 may include a drain D2 connected to the j-th data line DLj, a source S2 connected to the capacitor Cst, and a gate G2 receiving an i-th scan signal SCi. The second transistor T2 provides a data voltage Vd to the first transistor T1 in response to the i-th scan signal SCi.

The third transistor T3 may include a source S3 connected to the j-th reference line RLj, a drain D3 connected to the anode of the light emitting element OLED, and a gate G3 receiving an i-th sensing signal SSi. The j-th reference line RLj may receive a reference voltage Vr.

The capacitor Cst may store a voltage difference of various values depending on an input signal. For example, the capacitor Cst may store a voltage corresponding to a difference between a voltage transmitted from the second transistor T2 and the first voltage ELVDD.

In the inventive concept, an equivalent circuit of the pixel PXij is not limited to the equivalent circuit diagram shown in FIG. 4. In another embodiment of the inventive concept, the pixel PXij may be implemented in various forms for emitting light from the light emitting element OLED.

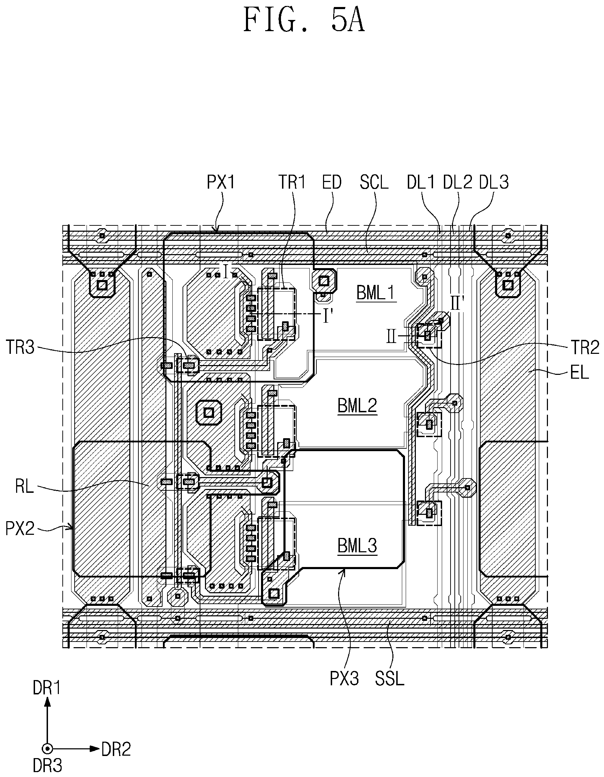

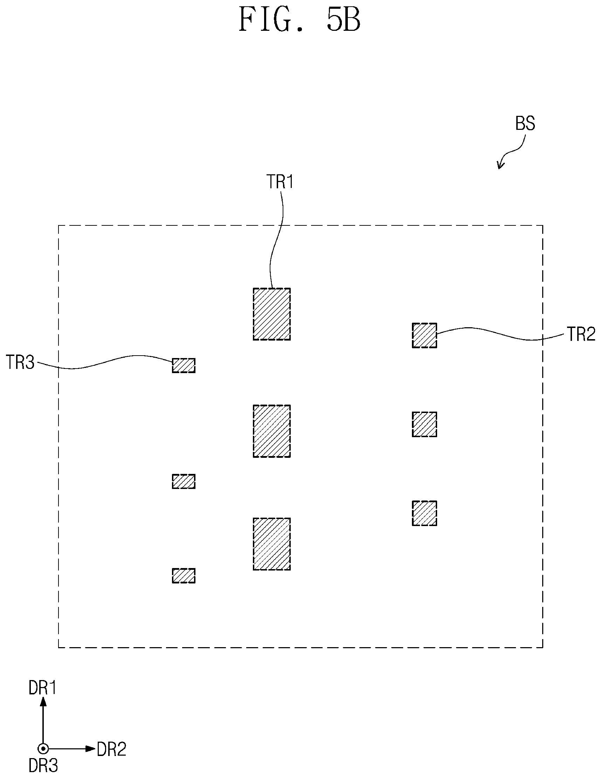

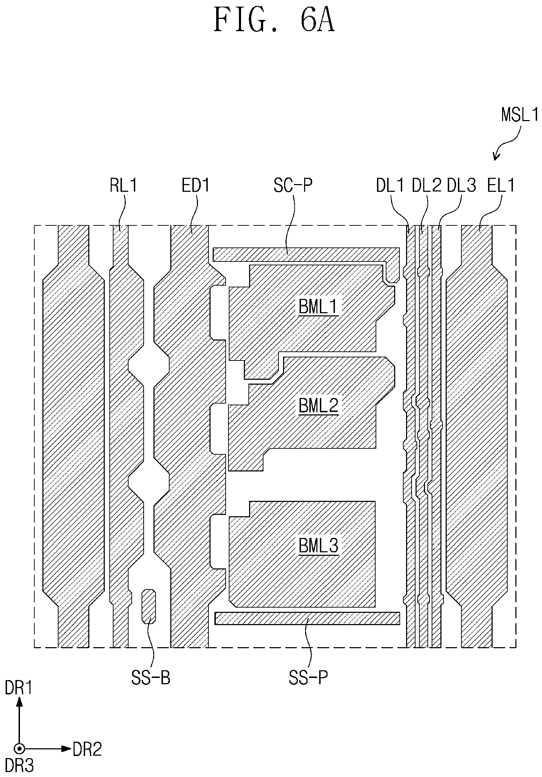

FIG. 5A is a plan view illustrating conductive patterns included in a pixel unit in a stacking order according to an embodiment of the inventive concept. FIG. 5B is a plan view of a base layer according to an embodiment of the inventive concept. FIGS. 6A to 6E are plan views in which conductive patterns included in a pixel unit is divided by layer in a stacking order according to an embodiment of the inventive concept, respectively.

FIG. 5A illustrates an arrangement of pixels PX1, PX2, and PX3 included in the pixel unit PXU (refer to FIG. 1A) and components included in a driving element, and FIGS. 6A to 6H illustrate components illustrated in FIG. 5A which are separated by layers.

The pixel unit PXU (refer to FIG. 1A) according to the inventive concept may include three pixels PX1, PX2, and PX3 and driving elements connected to the pixels PX1, PX2 and PX3. The pixels PX1, PX2, and PX3 are connected to a first power line ED, a second power line EL, a scan line SCL, and a sensing line SSL. In addition, the pixels PX1, PX2, and PX3 may be connected to corresponding data lines DL1, DL2, and DL3. The first power line ED may provide a first voltage ELVDD (refer to FIG. 4), and the second power line EL may provide a second voltage ELVSS (refer to FIG. 4) lower than the first voltage ELVDD.

Each of the pixels PX1, PX2, and PX3 according to the inventive concept may include first to third transistors T1, T2, and T3 (refer to FIG. 4) and a corresponding capacitor Cst (refer to FIG. 4). An equivalent circuit diagram of the first to third transistors T1, T2, and T3 (refer to FIG. 4) and the capacitor Cst (refer to FIG. 4) included in one of the first to third pixels PX1, PX2, and PX3 may correspond to the equivalent circuit diagram described with reference to FIG. 4.

Light blocking patterns BML1, BML2, and BML3 may be disposed under and correspond to the first transistors T1 included in the pixels PX1, PX2, and PX3, respectively. The light blocking patterns BML1, BML2, and BML3 may be connected to the corresponding first transistor T1, respectively, to form a sync structure.

Referring to FIG. 5B, a base layer BS according to an embodiment may include trenches TR1, TR2, and TR3 overlapping at least one of the first to third transistors T1, T2, and T3. The base layer BS may be partially removed in a direction from an upper surface of the base layer BS to a lower surface of the base layer BS, that is, in a thickness direction of the base layer BS to form the trenches TR1, TR2, and TR3. The trenches TR1, TR2, and TR3 may be formed by performing an etching process in the base layer BS.

FIG. 5B illustrates the first trench TR1 ("trench" in the claims) overlapping the first transistor T1 and the second trench TR2 ("sub-trench" in the claims) overlapping the second transistor T2, and the third trench TR3 overlapping the third transistor T3 which are included in the pixels PX1, PX2, and PX3, but the inventive concept is not limited thereto, and at least one of the second trench TR2 and the third trench TR3 may be omitted, and is not limited to any one embodiment. In addition, although the trenches TR1, TR2, and TR3 are illustrated in a rectangular shape in FIG. 5B, the inventive concept is not limited thereto, and the trenches TR1, TR2, and TR3 may have different shapes, and each of the trenches TR1, TR2, and TR3 may have a circular, elliptical, or polygonal shape.

Referring to FIGS. 5A and 6A, a first conductive layer MSL1 according to the inventive concept may include a first reference pattern RL1 included in a reference line RL, a common pattern ED 1 connected to the first power line ED, a plurality of light blocking patterns BML1, BML2, and BML3, first to third data lines DL1, DL2, and DL3, a first power pattern EL1 of the second power line EL, a scan pattern SC-P, a sensing bridge pattern SS-B, and a sensing pattern SS-P.

The first reference pattern RL1 included in the reference line RL may extend in the first direction DR1 and be disposed between the second power line EL of the adjacent pixel unit PXU and the common pattern ED1.

The common pattern ED1 may extend in the first direction DR1 and may be disposed between the first reference pattern RL1 and the light blocking patterns BML1, BML2, and BML3.

The light blocking patterns BMI,1, BML2, and BML3 may be arranged to be spaced apart from each other in the first direction DR1, and may be disposed between the common pattern ED1 and the first data line DL 1.

The first to third data lines DL1, DL2, and DL3 may be connected to corresponding pixels PX1, PX2, and PX3, respectively. Each of the first to third data lines DL1, DL2, and DL3 may extend in the first direction DR1 and may be arranged to be spaced apart from each other in the second direction DR2.

The first power pattern EL1 of the second power line EL may extend in the first direction DR1 and may be arranged to be spaced apart from the third data line DL3 in the second direction DR2.

The scan pattern SC-P may extend in the second direction DR2. On a plane view, the scan pattern SC-P may be disposed on the first light blocking pattern BML1, and may be disposed between the common pattern ED1 and the first data line DL1.

The sensing pattern SS-P may extend in the second direction DR2. On a plane view, the sensing pattern SS-P may be disposed under the third light blocking pattern BMI,3, and may be disposed between the common pattern ED1 and the first data line DL1.

The sensing bridge pattern SS-B may be disposed between the first reference pattern RL1 and the common pattern ED1.

The conductive patterns included in the first conductive layer MSL1 may be directly disposed on the base layer BS. Accordingly, the conductive patterns included in the first conductive layer MSL1 may be patterned through the same mask and include the same material. Hereinafter, conductive patterns disposed on the same conductive layer may be patterned through the same mask and include the same material.

The first conductive layer MSL1 may be covered by a first insulating layer 10 (refer to FIG. 7). The first insulating layer 10 may be a buffer layer.

Referring to FIGS. 5A and 6B, a second conductive layer MSL2 according to the inventive concept may be disposed on the first insulating layer 10 (refer to FIG. 7). The second conductive layer MSL2 may include first to third semiconductor patterns SC1, SC2, and SC3 corresponding to the first to third transistors T1, T2, and T3, respectively. In addition, the second conductive layer MSL2 may include capacitor patterns Cst-P.

The second semiconductor patterns SC2 may have an integral shape with the capacitor patterns Cst-P overlapping the corresponding light blocking patterns BML1, BML2, and BML3. For convenience of description, a portion constituting the semiconductor pattern of each of the second transistors T2 will be described as the second semiconductor pattern SC2.

According to an embodiment, the capacitor patterns Cst-P may constitute a capacitor Cst (refer to FIG. 4) together with the overlapping light blocking patterns BML1, BML2, and BML3.

The first semiconductor pattern SC1 included in the first transistor T1 may include a source S1, a drain D1, and a channel region A1. The channel region A1 may be disposed between the source S1 and the drain D1. The second semiconductor pattern SC2 included in the second transistor T2 may include a source S2, a drain D2, and a channel region A2. The channel region A2 may be disposed between the source S2 and the drain D2. The third semiconductor pattern SC3 included in the third transistor T3 may include a source S3, a drain D3, and a channel region A3. The channel region A3 may be disposed between the source S3 and the drain D3.

Regions included in the first to third semiconductor patterns SC1, SC2, and SC3, respectively, may be each divided into sources, drains, and channel regions after a reduction process is performed using a gate to be described later as a mask. However, the inventive concept is not limited thereto, and roles of the sources and drains respectively included in the first to third transistors T1, T2, and T3 may be changed depending on applied voltages. The first to third semiconductor patterns SC1, SC2, and SC3 may be each formed of an oxide semiconductor pattern. However, the inventive concept is not limited thereto, and the semiconductor patterns may be each formed of amorphous silicon or polycrystalline silicon, and the inventive concept is not limited thereto.

The second conductive layer MSL2 may be covered by a second insulating layer 20 (refer to FIG. 7).

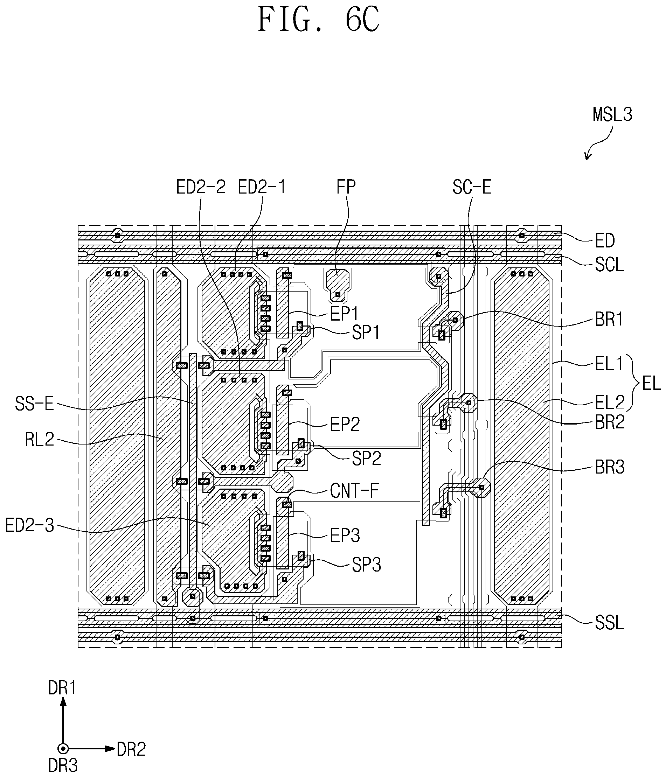

FIG. 6C illustrates patterns included in the third conductive layer MSL3. In addition, a plurality of contact holes formed through at least one of the first insulating layer 10, the second insulating layer 20, and the third insulating layer 30 are illustrated. The plurality of contact holes are illustrated in a rectangular shape for convenience of description, and separate reference numerals of the plurality of contact holes are omitted.

Referring to FIGS. 5A and 6C, the third conductive layer MSL3 according to the inventive concept may include a second reference pattern RL2 included in a reference line RL, a plurality of individual patterns ED2-1, ED2-2, and ED2-3 connected to the common pattern ED1, a second power pattern EL2 included in the second power line EL, a scan line SCL, a sensing line SSL, a first power line ED, a scan extension pattern SC-E, a sensing extension pattern SS-E, extension patterns EP1, EP2, and EP3, space patterns SP1, SP2, and SP3, bridge patterns BR1, BR2, and BR3, and a floating pattern FP.

The second reference pattern RL2 included in the reference line RL may extend in the first direction DR1 and overlap the first reference pattern RL1. The second reference pattern RL2 may be connected to the first reference pattern RL1 through a corresponding contact hole. The reference line RL according to the inventive concept may include the first reference pattern RL1 and the second reference pattern RL2 disposed on different layers, and thus resistance of the reference line RL may be reduced.

A portion of the second reference pattern RL2 may overlap the third semiconductor pattern SC3 included in each of the third transistors T3. The third semiconductor pattern SC3 overlapping a portion of the second reference pattern RL2 may be defined as the source S3 of each of the third transistors T3.

The sensing extension pattern SS-E may extend in the first direction DR1 and may be disposed between the second reference pattern RL2 and the individual patterns ED2-1, ED2-2, and ED2-3. A portion of the sensing extension pattern SS-E may overlap the third semiconductor pattern SC3 included in each of the third transistors T3. The third semiconductor pattern SC3 overlapping a portion of the sensing extension pattern SS-E may be defined as the channel region A3 of each of the third transistors T3, and a portion of the sensing extension pattern SS-E overlapping the channel region A3 may be defined as the gate G3 of each of the third transistors T3.

One end of the sensing bridge pattern SS-B may overlap the sensing extension pattern SS-E, and the other end of the sensing bridge pattern SS-B may overlap the sensing line SSL. The sensing extension pattern SS-E and the sensing line SSL overlapping the sensing bridge pattern SS-B may be connected to the sensing bridge pattern SS-B through corresponding contact holes.

The individual patterns ED2-1, ED2-2, and ED2-3 may overlap the common pattern ED1, and the individual patterns ED2-1, ED2-2, and ED2-3 may be arranged to be spaced part from each other in the first direction DR1. A portion of each of the individual patterns ED2-1, ED2-2, and ED2-3 may overlap the corresponding first semiconductor pattern SC1. The first semiconductor pattern SC1 overlapping a portion of each of the individual patterns ED2-1, ED2-2, and ED2-3 may be defined as the drain D1 of each of the first transistors T1.

The individual patterns ED2-1, ED2-2, and ED2-3 may be connected to the common pattern ED1 through corresponding contact holes. The common pattern ED1 may be connected to the first power line ED through a corresponding contact hole. Accordingly, the drain D1 of each of the first transistors T1 may be connected to the first power line ED to receive the first voltage ELVDD.

Each of the extension patterns EP1, EP2, and EP3 may extend in the first direction DR1. A portion of each of the extension patterns EP1, EP2, and EP3 may overlap a corresponding each of the first semiconductor patterns SC1, and another portion of each of the extension patterns EP1, EP2, and EP3 may overlap a corresponding each of the capacitor patterns Cst-P. Another portion of each of the extension patterns EP1, EP2, and EP3 may be connected to a corresponding each of the capacitor patterns Cst-P through a corresponding contact hole.

The first semiconductor patterns SC1 overlapping a portion of each of the extension patterns EP1, EP2, and EP3 may be defined as the channel regions A1 of the first transistors T1, respectively, and the extension patterns EP1, EP2, and EP3 overlapping the corresponding channel regions A1 may be defined as gates G1 of the first transistors T1, respectively.

The bridge patterns BR1, BR2, and BR3 may connect the corresponding second semiconductor patterns SC2 and the corresponding first to third data lines DL1, DL2, and DL3. One end of each of the bridge patterns BR1, BR2, and BR3 may overlap the corresponding second semiconductor patterns SC2 and may be connected to the corresponding second semiconductor patterns SC2 through a corresponding contact hole.

The other end of each of the bridge patterns BR1, BR2, and BR3 may overlap the corresponding first to third data lines DL1, DL2, and DL3. The second bridge pattern BR2 may cross the first data line DL1 and may overlap the second data line DL2, and the third bridge pattern BR3 may cross the first and second data lines DL1 and DL2 and may overlap the third data line DL3. The other end of each of the bridge patterns BR1, BR2, and BR3 may be connected to the corresponding first to third data lines DL1, DL2, and DL3 through a corresponding contact hole.

The second semiconductor pattern SC2 overlapping one end of each of the bridge patterns BR1, BR2, and BR3 may be defined as the drain D2 of each of the second transistor T2.

The scan extension pattern SC-E may extend in the first direction DR1. A portion of the scan extension pattern SC-E may overlap the second semiconductor pattern SC2 included in each of the second transistors T2.

The second semiconductor pattern SC2 overlapping a portion of the scan extension pattern SC-E may be defined as the channel region A2 of each of the second transistors T2, a portion of the scan extension pattern SC-E overlapping the channel region A2 may be defined as the gate G2 of each of the second transistors T2.

One end of the scan extension pattern SC-E may overlap the scan pattern SC-P and may be connected to the scan pattern SC-P through a corresponding contact hole.

The scan line SCL may overlap the scan pattern SC-P and may be connected to the scan pattern SC-P through corresponding contact holes. Accordingly, the scan line SCL and the scan extension pattern SC-E may be electrically connected, and the gate G2 of each of the second transistors T2 may receive the scan signal Sci (refer to FIG. 4).

The second power pattern EL2 included in the second power line EL may extend in the first direction DR1 and overlap the first power pattern EL1. The second power pattern EL2 may be connected to the first power pattern EL1 through corresponding contact holes. The first power pattern EL1 may be connected to the second power pattern EL2 through a corresponding contact hole. The second power line EL according to the inventive concept may include the first power pattern EL1 and the second power pattern EL2 disposed on different layers, and thus resistance of the second power line EL may be reduced.

The sensing line SSL may overlap the sensing pattern SS-P and may be connected through corresponding contact holes.

One end of each of the space patterns SP1, SP2, and SP3 may overlap each of corresponding first semiconductor patterns SC1 and may be connected to each of the corresponding first semiconductor patterns SC1 through a corresponding contact hole. The other end of each of the space patterns SP1, SP2, and SP3 may overlap each of the corresponding third semiconductor patterns SC3 and may be connected to each of the corresponding third semiconductor patterns SC3 through a corresponding contact hole.

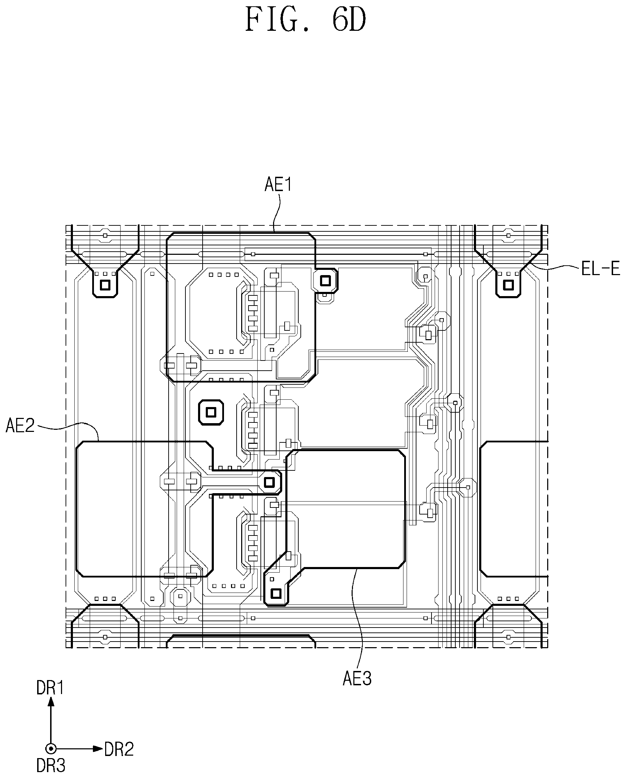

Each of the first semiconductor patterns SC1 overlapping one end of each of the space patterns SP1, SP2, and SP3 may be defined as the source S1 of the first transistor T1. Each of the third semiconductor patterns SC3 overlapping the other ends of each of the intervening patterns SP1, SP2, and SP3 may be defined as the drain D3 of the third transistor T3. Anodes AE2 and AE3 (refer to FIG. 6D) to be described later may be connected to the second space pattern SP2 and the third space pattern SP3.

The source S1 of the first transistor T1 may be connected to a corresponding one of the light blocking patterns BMI,1, BML2, and BMI,3, the light blocking patterns BML1, BML2, and BML3 may receive a signal applied to the source S1, and a sync structure may be formed under the first semiconductor pattern SC1.

Among the conductive patterns included in the third conductive layer MSL3, a portion overlapping the sources S1, S2, and S3 included in the first to third transistors T1, T2 and T3 may be defined as a "first electrode", and a portion overlapping the drains D1, D2, and D3 may be defined as a "second electrode".

On a plane view, the floating pattern FP may be at least partially surrounded by the capacitor pattern Cst-P included in the first pixel PX1 (refer to FIG. 5A). An anode AE1 (refer to FIG. 6D) to be described later may be connected to the floating pattern FP.

According to an embodiment, the conductive patterns included in the third conductive layer MSL3 may include a plurality of layers including different metals. The conductive patterns included in the third conductive layer MSL3 may include a lower layer including titanium (Ti), an intermediate layer including copper (Cu), and an upper layer including a transparent conductive oxide. The transparent conductive oxide may include indium tin oxide (ITO). The upper layer including ITO may prevent some conductive patterns of the third conductive layer MSL3 exposed to the outside from oxidation.

The third conductive layer MSL3 may be covered by a third insulating layer 30 (refer to FIG. 7). A fourth insulating layer 40 (refer to FIG. 7) may be disposed on the third insulating layer 30 (refer to FIG. 7).

In the display panel DP according to an embodiment, some of the conductive patterns included in the third conductive layer MSL3 may be connected to conductive patterns included in the additional conductive layer disposed on the third conductive layer MSL3 to be provided as multiple layers, or may be omitted in the third conductive layer MSL3 and only in the additional conductive layer. In this case, at least one mask for forming conductive patterns included in the additional conductive layer may be additionally required, in addition to the mask for forming the conductive patterns included in the third conductive layer MSL3 described with reference to FIG. 6C. An additional insulating layer may be further included between the third conductive layer MSL3 and the additional conductive layer. When the semiconductor patterns SC1, SC2, and SC3 included in each of the first to third transistors T1, T2, and T3 (refer to FIG. 6B ) overlap one of the trenches TR1, TR2, and TR3 (refer to FIG. 5B) formed in the base layer BS, the present invention may be applied regardless of the number of masks forming the conductive patterns. FIG. 6D illustrates anodes AE1, AE2, and AE3 and an electrode pattern EL-E included in the light emitting element OLED (refer to FIG. 4).

The anodes AE1, AE2, and AE3 may be disposed on the fourth insulating layer 40 (refer to FIG. 7). Each of the anodes AE1, AE2, and AE3 may be connected to the floating pattern FP and the second and third space patterns SP2 and SP3 through the contact holes through which the third insulating layer 30 (refer to FIG. 7) and the fourth insulating layer 40 (refer to FIG. 7) pass. For example, the first anode AE1 may be connected to the floating pattern FP through a corresponding contact hole, the second anode AE2 may be connected to the second space pattern SP2 through a corresponding contact hole, and the third anode AE3 may be connected to the third space pattern SP3 through a corresponding contact hole. The areas of the anodes AE1, AE2, and AE3 included in each of the pixels providing different light may be different from each other.

The electrode pattern EL-E may be connected to the second power line EL through a corresponding contact hole.

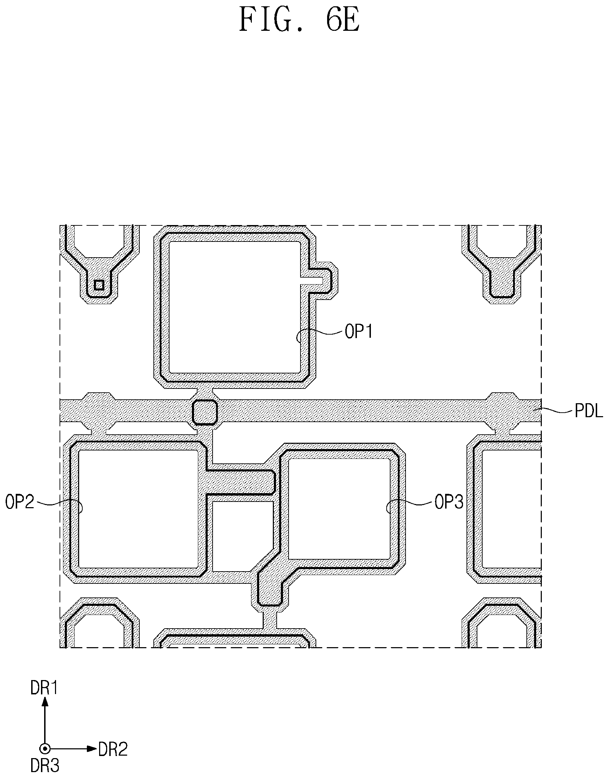

FIG. 6E illustrates a pixel defining layer PDL. The pixel defining layer PDL may be disposed on the fourth insulating layer 40 (refer to FIG. 7) and may include a first to third openings OP1, OP2, and OP3 exposing at least portion of the corresponding anodes AE1, AE2, and AE3. In addition, the pixel defining layer PDL may include an additional opening exposing at least a portion of the electrode pattern EL-E.

A region exposed by the corresponding first to third openings OP1, OP2, and OP3 among the anodes AE1, AE2, and AE3 may be defined as a light emitting region to which light generated from the light emitting element OLED (refer to FIG. 7) is provided, and a region overlapping the pixel defining layer PDL may be defined as a non-light emitting region.

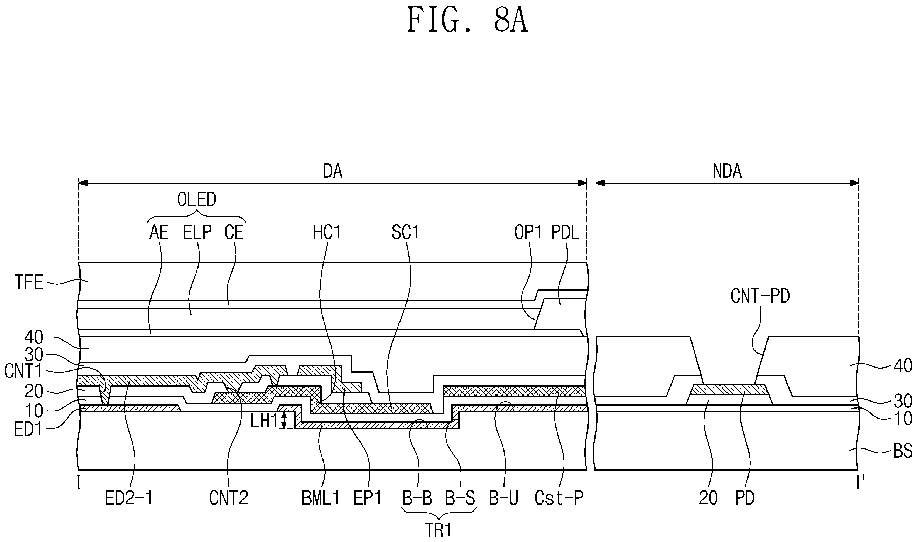

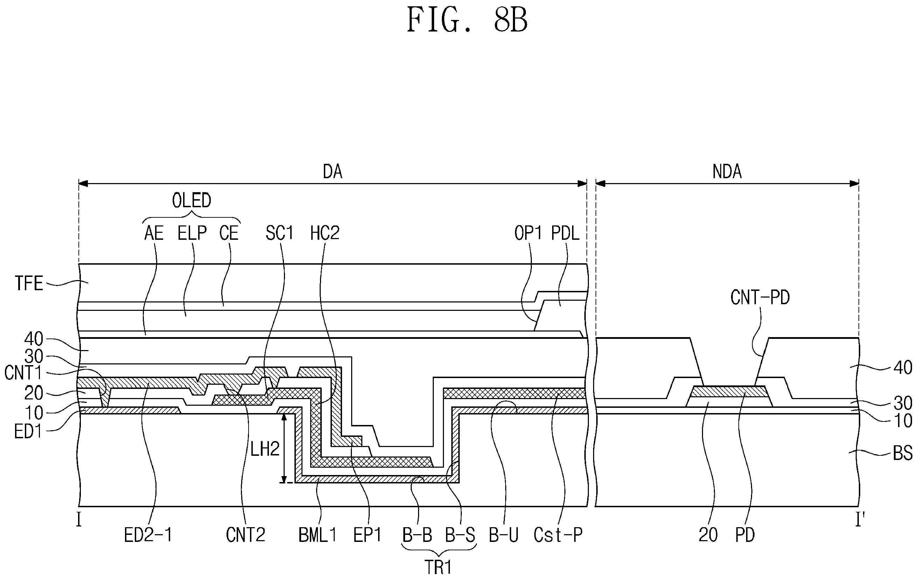

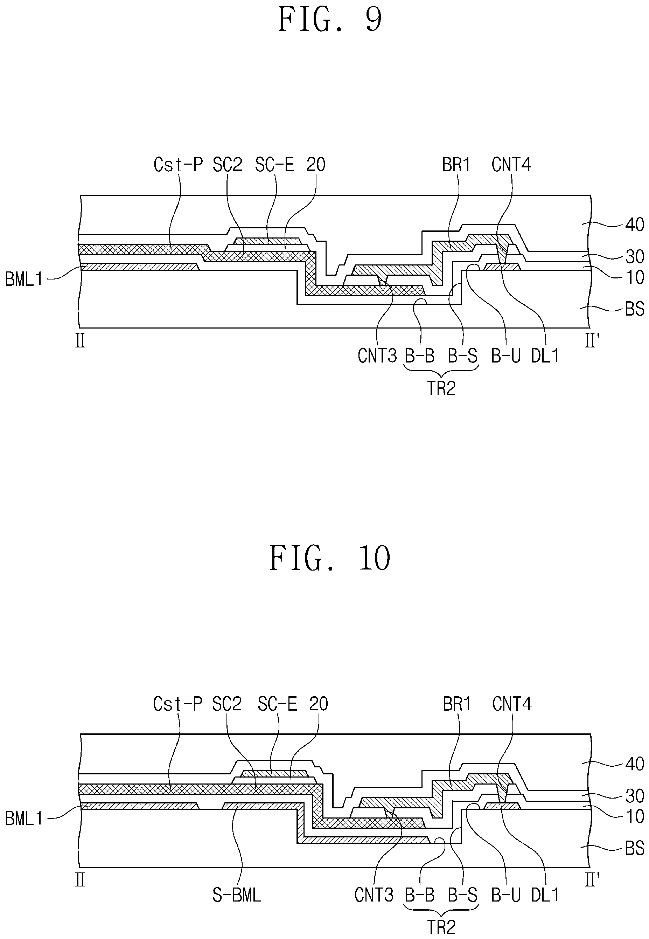

FIG. 7 is a cross-sectional view taken along line I-I' of FIG. 5A. FIG. 8A is a cross-sectional view taken along line I-I' of FIG. 5A according to an embodiment. FIG. 8B is a cross-sectional view of a display panel according to an embodiment. FIG. 9 is a cross-sectional view taken along line II-II' of FIG. 5A. FIG. 10 is a cross-sectional view of another embodiment taken along line II-II' of FIG. 5A. The same/similar reference numerals are used for the same/similar components as those described with reference to FIGS. 5A to 6E, and repeated descriptions are omitted.

Referring to FIG. 7, a base layer BS according to an embodiment may include a first trench TR1. An upper surface B-U of the base layer BS may be partially removed in a thickness direction, that is, in a third direction DR3 to form the first trench TR1. In other words, the base layer BS includes a first region formed by partially removing the base layer BS from the upper surface B-U of the base layer BS in a thickness direction of the base layer BS and a second region surrounding the first region.

The first trench TR1 according to an embodiment may be defined by a side surface B-S of the base layer BS and a bottom surface B-B connected to the side surface B-S which are formed by partially removing the base layer BS. In this embodiment, an angle between the side surface B-S and the bottom surface B-B may be a right angle.

A first light blocking pattern BML1 and a common pattern ED1 may be disposed on the base layer BS and covered by a first insulating layer 10.

At least a portion of the first light blocking pattern BML1 according to an embodiment may overlap the first trench TR1. In other words, the first light blocking pattern BML1 at least partially overlaps the first region in a plan view. Accordingly, the first light blocking pattern BML1 may include a first pattern in contact with the upper surface B-U of the base layer BS, a second pattern in contact with the side surface B-S of the base layer BS, and a third pattern in contact with the bottom surface B-B of the base layer BS.

A first semiconductor pattern SC1 and a capacitor pattern Cst-P may be disposed on the first insulating layer 10, and at least a portion thereof may be covered by a second insulating layer 20. As the second insulating layer 20 is patterned using a third conductive layer MSL3 (refer to FIG. 6C) as a mask, a shape of the second insulating layer 20 may correspond a shape of each of the conductive patterns included in the third conductive layer MSL3 (refer to FIG. 6C) on a plane view.

At least a portion of the first semiconductor pattern SC1 according to an embodiment may overlap the first trench TR1. Accordingly, the first semiconductor pattern SC1 may include a first portion disposed on the upper surface B-U of the base layer BS, a second portion HC parallel to the side surface B-S of the base layer BS, and a third portion disposed on the bottom surface B-B of the base layer BS.

The first portion of the first semiconductor pattern SC1 may overlap the first pattern of the first light blocking pattern BMI,1 on a plane view, and the third portion of the first semiconductor pattern SC1 may overlap the third pattern of the first light blocking pattern BML1 on a plane view. The second portion HC of the first semiconductor pattern SC1 may face the second pattern of the first light blocking pattern BML1. The first semiconductor pattern SC1 faces the first light blocking pattern BML1 and is disposed in the first region and a portion of the second region adjacent to the first region. According to an embodiment, the second portion HC of the first semiconductor pattern SC1 may be parallel to the side surface B-S of the base layer BS.

A first individual pattern ED2-1, a first extension pattern EP1, and a pad PD may be disposed on the second insulating layer 20 and covered by a third insulating layer 30. According to an embodiment, the third insulating layer 30 may be in contact with a portion of the first semiconductor pattern SC1.

One end of the first individual pattern ED2-1 may be connected to the common pattern ED1 through a first contact hole CNT1 defined in the first and second insulating layers 10 and 20. The other end of the first individual pattern ED2-1 may be connected to a first portion of the first semiconductor pattern SC1 through a second contact holes CNT2 defined in the second insulating layer 20. A portion of the first semiconductor pattern SC1 that overlaps the first individual pattern ED2-1 may be defined as a drain D1 (refer to FIG. 6B) of a first transistor T1 (refer to FIG. 4).

The first extension pattern EP1 may overlap the first semiconductor pattern SC1. A portion of the first semiconductor pattern SC1 that overlaps the first extended pattern EP1 may be defined as a channel region A1 (refer to FIG. 6B) of the first transistor T1 (refer to FIG. 4). In addition, a portion of the first extension pattern EP1 that overlaps a channel region A1 (refer to FIG. 6B) may be defined as a gate G1 (refer to FIG. 4) of the first transistor T1 (refer to FIG. 4).

The channel region A1 (refer to FIG. 6B) of the first semiconductor pattern SC1 may be formed to include the second portion HC of the first semiconductor pattern SC1, the first portion adjacent to the second portion HC, and a third portion. According to an embodiment, the channel region A1 (refer to FIG. 6B) may include the second portion HC parallel to the side surface B-S of the base layer BS. Accordingly, a design for the channel region A1 (refer to FIG. 6B) included in the first semiconductor pattern SC1 according to the inventive concept may be changed depending on a width of the side surface B-S of the base layer BS defining the first trench TR1.

FIG. 8A illustrates a second portion HC1 of the channel region A1 (refer to FIG. 6B) corresponding to the side surface B-S of the base layer BS having a first width LH1, and FIG. 8B illustrates a second portion HC2 of the channel region A1 (refer to FIG. 6B) corresponding to the side surface B-S of the base layer BS having a second width LH2. According to an embodiment, the first width LH1 may be greater than or equal to 0.5 µm, and the second width LH2 may be less than or equal to 500 µm. Accordingly, a width of the second portion HC1 parallel to the side surface B-S of the channel region A1 (refer to FIG. 6B) may also have a value of 0.5 µm or more to 500 µm or less. In addition, a design for a width of the gate G1 (refer to FIG. 4) forming the channel region A1 (refer to FIG. 6B) of the first transistor T1 (refer to FIG. 4) may be changed to correspond to the width of the side surface B-S of the base layer BS.

According to the inventive concept, a design for a width of the channel region A1 (refer to FIG. 6B) may be easily changed to correspond to a width change value of the side surface B-S of the base layer BS. That is, when it is necessary to decrease the width of the channel region A1 (refer to FIG. 6B), the width of the side surface B-S may be designed to be small in forming the trench TR1, and when it is necessary to increase the width of the channel region A1 (refer to FIG. 6B), the width of the side surface B-S may be designed to be large in forming the trench TR1, thereby easily increasing or decreasing the width of the channel region A1 (refer to FIG. 6b). Accordingly, a high-resolution display panel DP (refer to FIG. 1A) may be provided.

In addition, in the flexible display panel DP-1 as shown in FIG. 1B, the channel region A1 (refer to FIG. 6B ) may be formed in a vertical direction parallel to the side surface B-S of the base layer BS may be prevent damage to the channel region A1 (refer to FIG. 6B) during being bent or curved, compared to when the channel region A1 (refer to FIG. 6B ) is formed in a horizontal direction of the base layer BS. Accordingly, the display panel DP-1 (refer to FIG. 1B) with improved durability may be provided.

A fourth insulating layer 40 may be disposed on the third insulating layer 30. The fourth insulating layer 40 may include an organic material and provide a flat surface for components disposed on the fourth insulating layer 40.

An anode AE and a pixel defining layer PDL may be disposed on the fourth insulating layer 40. A first opening OP1 exposing at least a portion of the anode AE may be defined in the pixel defining layer PDL. A light emitting pattern ELP may overlap the first opening OP1, and a cathode CE may be disposed on the light emitting pattern ELP and the pixel defining layer PDL.

The pad PD may be disposed on the second insulating layer 20 and may overlap the non-display area NDA. The pad PD may be exposed to the outside through a pad contact holes CNT-PD defined in the third and fourth insulating layers 30 and 40. The pad PD may correspond to the pad PD described with reference to FIG. 3. The pad PD may be a portion of the conductive patterns of the third conductive layer MSL3 described with reference to FIG. 6C. The conductive patterns included in the third conductive layer MSL3 (refer to FIG. 6C) may include a lower layer including titanium (Ti), an intermediate layer including copper (Cu), and an upper layer including a transparent conductive oxide. The transparent conductive oxide may include indium tin oxide (ITO). The upper layer including ITO may prevent the pad PD exposed to the outside from oxidation.

FIGS. 9 and 10 are embodiments of a second trench TR2 overlapping a second semiconductor pattern SC2 of a second transistor T2 (refer to FIG. 4).

The base layer BS according to an embodiment may include a second trench TR2. A portion of the second trench TR2 may be removed from the upper surface B-U of the base layer BS in the thickness direction, that is, in the third direction DR3. The second trench TR2 may be spaced apart from the first trench TR1 (refer to FIG. 7).

The second trench TR2 according to an embodiment may be defined by a side surface B-S of the base layer BS and a bottom surface B-B connected to the side surface B-S which are formed by partially removing the base layer BS. In this embodiment, an angle between the side surface B-S and the bottom surface B-B may be a right angle.

The first light blocking pattern BML1 and a first data line DL1 may be disposed on the base layer BS and covered by the first insulating layer 10.

A second semiconductor pattern SC2 and the capacitor pattern Cst-P may be disposed on the first insulating layer 10, and at least a portion thereof may be covered by the second insulating layer 20. The second semiconductor pattern SC2 and the capacitor pattern Cst-P may be provided integrally, and for convenience of description, the second semiconductor pattern SC2 and the capacitor pattern Cst-P will be described separately.

At least a portion of the second semiconductor pattern SC2 according to an embodiment may overlap the second trench TR2. Accordingly, the second semiconductor pattern SC2 may include a first portion disposed on the upper surface B-U of the base layer BS, a second portion parallel to the side surface B-S, and a third portion disposed on the bottom surface B-B of the base layer BS.

The second semiconductor pattern SC2 overlapping a portion of the scan extension pattern SC-E may be defined as a channel region A2 (refer to FIG. 6B) of a second transistor T2 (refer to FIG. 4), and a portion of the scan extension pattern SC-E overlapping the channel region A2 may be defined as a gate G2 (refer to FIG. 4) of the second transistor T2.

One end of a first bridge pattern BR1 may be connected to the second semiconductor pattern SC2 through a third contact hole CNT3 defined in the second insulating layer 20, and the other end of the first bridge pattern BR1 may be connected to the first data line DL1 through a fourth contact hole CNT4 defined in the first insulating layer 10 and the second insulating layer 20.

The second semiconductor pattern SC2 overlapping a portion of the first bridge pattern BR1 may be defined as a drain D2 (refer to FIG. 6B) of the second transistor T2 (refer to FIG. 4), and a portion of the first bridge pattern BR1 overlapping the drain D2 (refer to FIG. 6B ) may be defined as a second electrode of the second transistor T2.

A portion of the second semiconductor pattern SC2 excluding the channel region A2 (refer to FIG. 6B) and the drain D2 (refer to FIG. 6B) may be defined as a source S2 (refer to FIG. 6B). The source S2 (refer to FIG. 6B) may be connected to the capacitor pattern Cst-P.

According to the inventive concept, a design for a width of the channel region A2 (refer to FIG. 6B) of the second transistor T2 (refer to FIG. 4) may be easily changed to correspond to a width change value of the side surface B-S defining the second trench TR2 of the base layer BS.

Referring to FIG. 10, the display panel according to an embodiment may further include a sub-light blocking pattern S-BMI, disposed on the base layer BS. At least a portion of the sub-light blocking pattern S-BMI, may be disposed in the second trench TR2 and may overlap the second semiconductor pattern SC2. According to an embodiment, the second semiconductor pattern SC2 may be connected to the sub-light blocking pattern S-BML. However, the inventive concept is not limited thereto, and the second semiconductor pattern SC2 may be insulated from the sub-light blocking pattern S-BML through the first insulating layer 10.

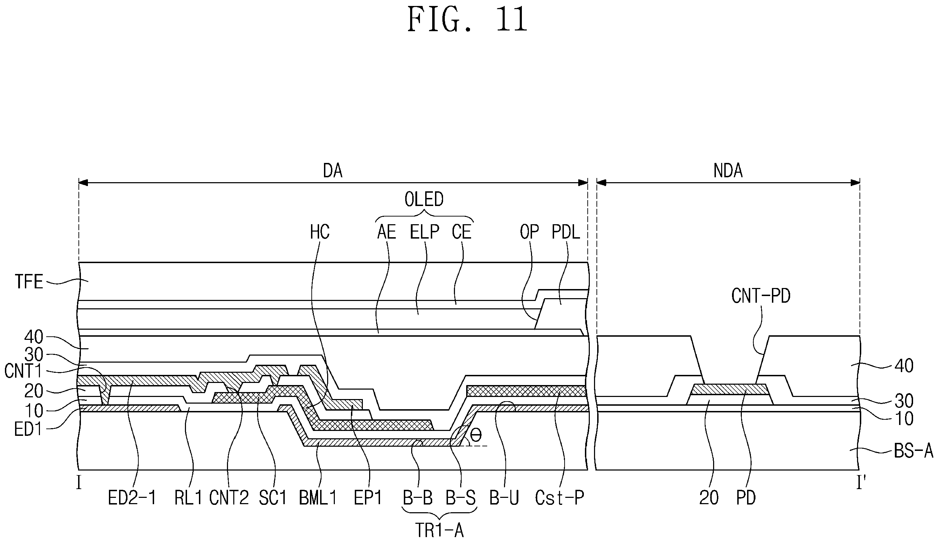

The structure described with reference to FIGS. 9 and 10 may be equally applied to a third trench TR3 (refer to FIG. 5B) overlapping a third semiconductor pattern SC3 (refer to FIG. 6B) of a third transistor T3 (refer to FIG. 4). Accordingly, a design for a width of a channel region A3 (refer to FIG. 6B) of the third transistor T3 (refer to FIG. 4) may be easily changed to correspond to a width change value of the side of the base layer BS defining the third trench TR3. FIG. 11 is a cross-sectional view of a display panel according to an embodiment of the inventive concept. The same/similar reference numerals are used for the same/similar components as those described in FIG. 7, and repeated descriptions are omitted.

Referring to FIG. 11, a base layer BS according to an embodiment may include trench TR1-A. A portion of the trench TR1-A may be removed from the upper surface B-U of the base layer BS in the thickness direction, that is, in the third direction DR3.

The trench TR1-A according to an embodiment may be defined by a side surface B-S of the base layer BS and a bottom surface B-B connected to the side surface B-S which are formed by partially removing the base layer BS. In the present embodiment, the side surface B-S may be inclined at a certain angle from the bottom surface B-B. For example, an angle Θ between an extension line (shown as a dotted line) parallel to the bottom surface B-B and the side surface B-S may be 30 degrees or more and 90 degrees or less. That is, an angle between the bottom surface B-B and the side surface B-S may be 90 degrees or more and 150 degrees or less.

At least a portion of each of the first light blocking pattern BMI,1, the first semiconductor pattern SC1, and the first extension pattern EP1 according to an embodiment may overlap the trench TR1-A. Accordingly, a portion of the first semiconductor pattern SC1 overlapping the first extension pattern EP1 and defined as the channel region A1 (refer to FIG. 6B ) of the first transistor T1 (refer to FIG. 4) may be inclined to correspond to an angle at which the side surface B-S of the trench TR1-A is inclined with respect to the bottom surface B-B of the trench TR1-A. According to the present embodiment, a design for a width of the channel region A1 (refer to FIG. 6B) may be easily changed to correspond to a width change value of the side surface B-S of the base layer BS.

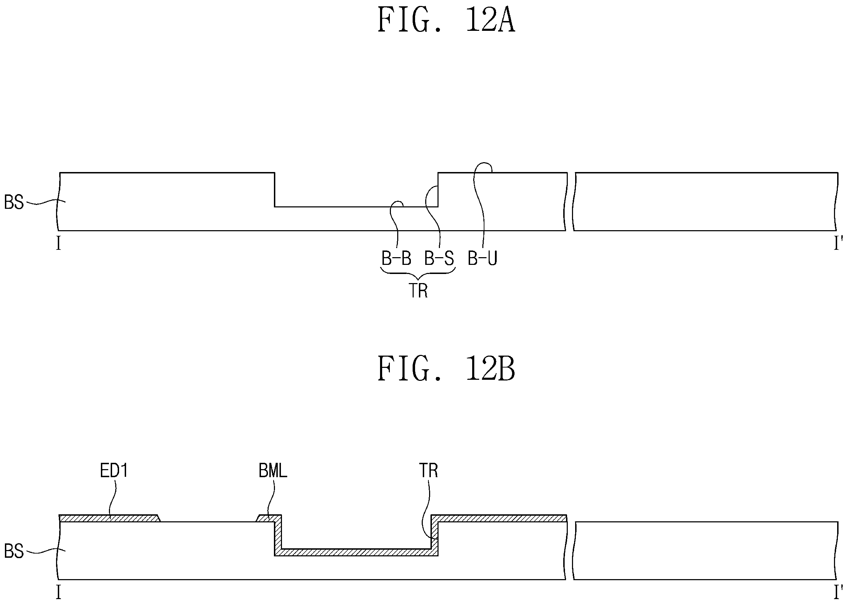

FIGS. 12A to 12H are cross-sectional views illustrating a method of manufacturing a display panel according to an embodiment. The same/similar reference numerals are used for the same/similar components as those described with reference to FIGS. 5A to 7, and repeated descriptions will be omitted. Hereinafter, a method of manufacturing a display panel according to an embodiment of the inventive concept will be described with reference to FIGS. 12A to 12H.

Referring to FIG. 12A, a method of manufacturing a display panel according to an embodiment may include forming a trench TR. The trench TR may be formed by removing a portion from an upper surface B-U of a base layer BS in a thickness direction. The trench TR may be defined by a side surface B-S of the base layer BS and a bottom surface B-B connected to the side surface B-S which are formed by removing a portion of the base layer BS. The trench TR1 may be formed by performing an etching process on the base layer BS. A width in the thickness direction of the side surface B-S may be 0.5um or more and 500um or less.

The side surface B-S according to an embodiment may be inclined to have an angle between 90 degrees and 150 degrees with respect to the bottom surface B-B.

Thereafter, referring to FIG. 12B, the method of manufacturing the display panel according to an embodiment may include forming a first conductive layer. The first conductive layer may include a light blocking pattern BML and a common pattern ED1. The light blocking pattern BML and the common pattern ED1 may be directly formed on the base layer BS.

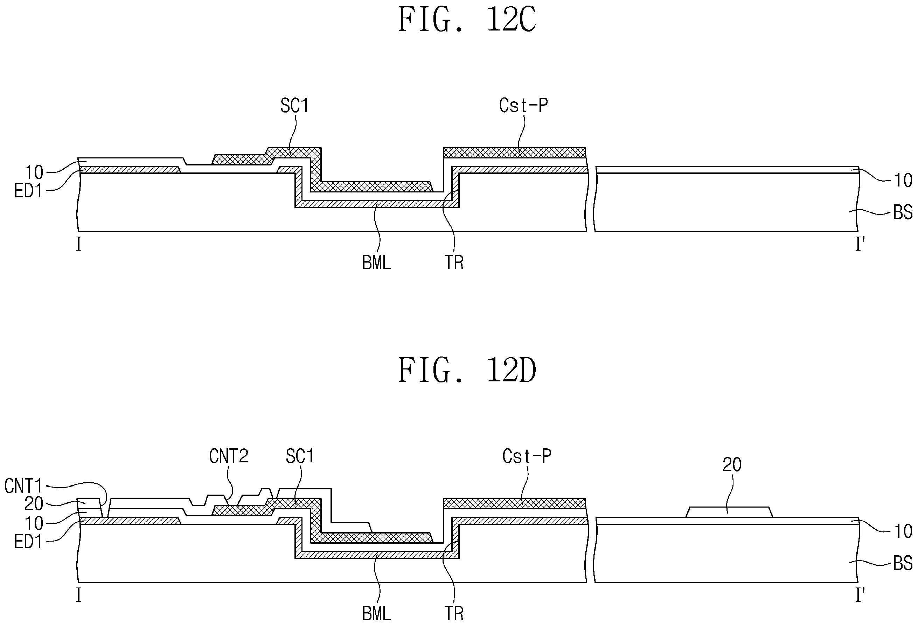

Thereafter, referring to FIG. 12C, the method of manufacturing the display panel according to an embodiment may include forming a first insulating layer 10 and forming a second conductive layer. The first insulating layer 10 may cover the first conductive layer and may be formed on the base layer BS. The second conductive layer may include a semiconductor pattern SC1 and a capacitor pattern Cst-P. At least a portion of the semiconductor pattern SC1 may be formed to overlap the trench TR. The capacitor pattern Cst-P and the light blocking pattern BML may constitute the capacitor Cst described with reference to FIG. 4.

Thereafter, referring to FIG. 12D, the method of manufacturing the display panel according to an embodiment may include forming a second insulating layer 20 and forming a third conductive layer.

A first contact hole CNT1 exposing a portion of the common pattern ED1 and second contact holes CNT2 exposing a portion of the semiconductor pattern SC1 (refer to FIG. 6B) may be formed in the second insulating layer 20.

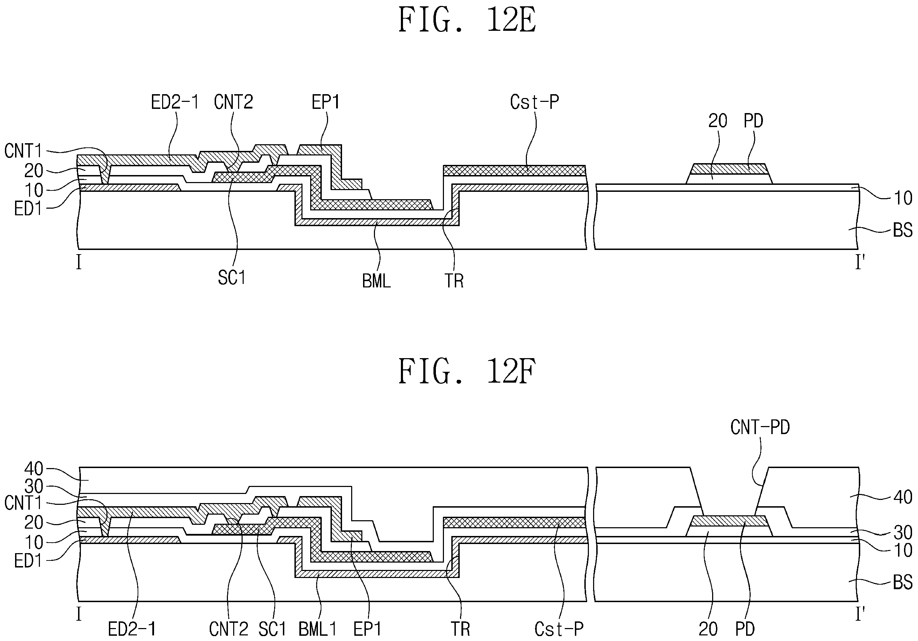

Thereafter, referring to FIG. 12E, the method of manufacturing the display panel according to an embodiment may include forming a third conductive layer. The third conductive layer may include a first individual pattern ED2-1, a first extension pattern EP1, and a pad PD. One end of the first individual pattern ED2-1 may be connected to the common pattern ED 1 through the first contact hole CNT1, and the other end of the first individual pattern ED2-1 may be connected to the semiconductor pattern SC1 (refer to FIG. 6B) through the second contact holes CNT2. The other end of the first individual pattern ED2-1 overlapping the semiconductor pattern SC1 may be defined as a second electrode.

Although not shown, a conductive pattern overlapping a portion defined as a source S1 of the semiconductor pattern SC1 (refer to FIG. 6B) among the conductive patterns included in the third conductive layer may be defined as a first electrode.

The first extension pattern EP1 may be formed to overlap the semiconductor pattern SC1. A portion of the semiconductor pattern SC1 that overlaps the first extended pattern EP1 may be defined as a channel region A1 (refer to FIG. 6B) of a first transistor T1 (refer to FIG. 4). In addition, a portion of the first extension pattern EP1 that overlaps the channel region A1 may be defined as a gate G1 (refer to FIG. 4) of the first transistor T1 (refer to FIG. 4).

According to the present embodiment, the gate G1, the first electrode, and the second electrode may be formed on the second insulating layer 20 and may be formed through the same mask. Accordingly, the gate G1, the first electrode, and second electrode may include the same material.

In the method of manufacturing the display panel according to the present embodiment, the first electrode and the second electrode connected to the semiconductor pattern SC1 may be formed on the same layer as the gate G1, thereby reducing the number of masks used in the method of manufacturing the display panel. The inventive concept may provide the method of manufacturing the display panel where a process is simplified, cost and process time are reduced.

Afterwards, referring to FIG. 12F, the method of manufacturing the display panel according to an embodiment may include forming a third insulating layer 30 and a fourth insulating layer 40. The pad PD may be exposed to the outside through a pad contact hole CNT-PD defined in the third and fourth insulating layers 30 and 40.

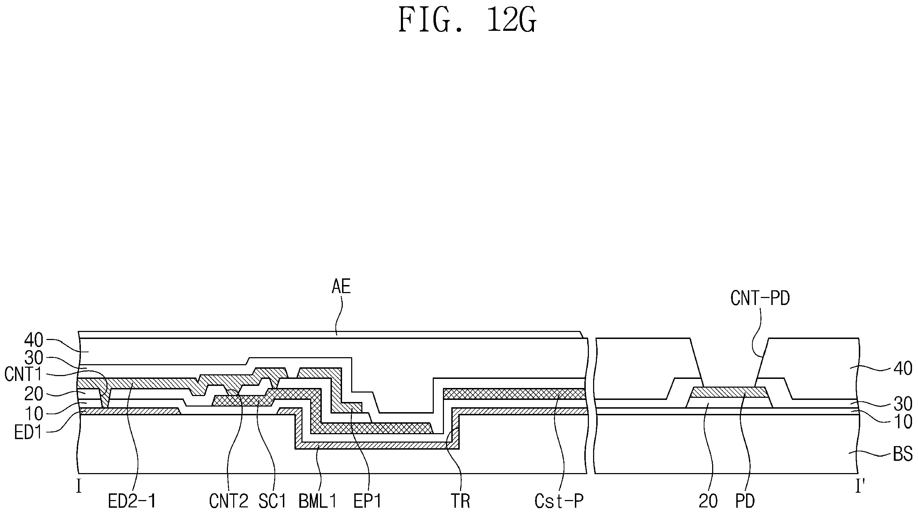

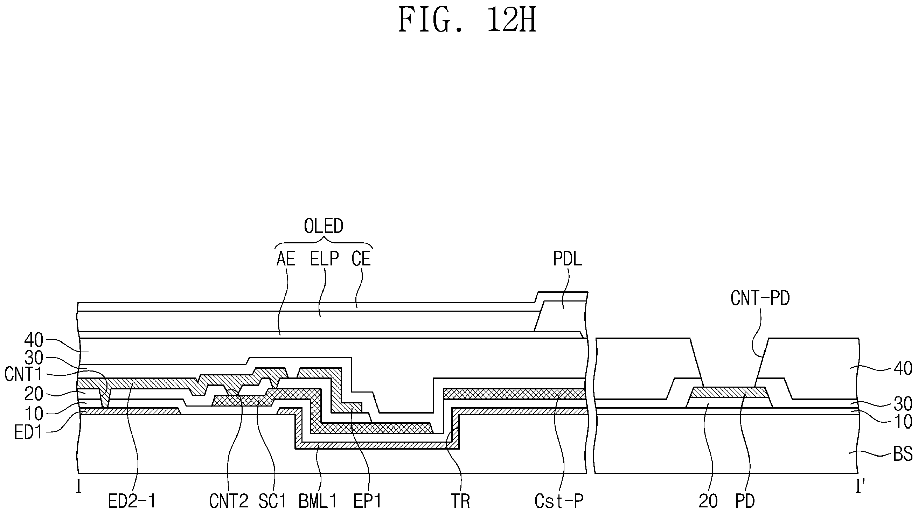

Thereafter, referring to FIGS. 12G and 12H, the method of manufacturing the display panel according to an embodiment may include forming an anode AE, forming a pixel defining layer PDL having an opening defined therein, and forming an light emitting pattern ELP, and forming a cathode CE.

According to the inventive concept, the design for the width of the channel region included in the transistor may be easily changed to correspond to the width change value of the side surface of the base layer. Accordingly, the high-resolution display panel may be provided.

In addition, in the flexible display panel, the channel region may be prevented from being damaged. Accordingly, the display panel with the improved durability may be provided.

Although the inventive concept has been described with a number of example embodiments, it is intended that the inventive concept encompass such various changes and modifications to one skilled in the art as fall within the scope of the appended claims.

Accordingly, the example embodiments of the inventive concept should be considered in all respects as illustrative and not restrictive, with the scope of the inventive concept being indicated by the appended claims.

## Claims

1. A display panel comprising:
a base layer including an upper surface and a lower surface opposite to the upper surface, partially removed from the upper surface in a thickness direction, and including a trench defined by a side surface connected to the upper surface and a bottom surface connected to the side surface;
a light blocking pattern at least partially overlapping the trench and disposed on the base layer; and
a pixel including a first transistor including a semiconductor pattern at least partially overlapping the trench, a first electrode, a second electrode, and a gate, and a light emitting element connected to the first transistor,
wherein at least a portion of the semiconductor pattern is parallel to the side surface.

2. The display panel of claim 1, wherein the semiconductor pattern includes a first portion parallel to the upper surface, a second portion parallel to the side surface, and a third portion parallel to the bottom surface.

3. The display panel of claim 1 or claim 2, wherein the light blocking pattern includes a first pattern in contact with the upper surface, a second pattern in contact with the side surface, and a third pattern in contact with the bottom surface.

4. The display panel of any proceeding claim, further comprising a first insulating layer covering the light blocking pattern and disposed on the base layer, a second insulating layer covering the semiconductor pattern and disposed on the first insulating layer, a third insulating layer covering the gate and disposed on the second insulating layer, and a fourth insulating layer dispose don the third insulating layer,
wherein the light emitting element is connected to the semiconductor pattern through a first contact hole defined in the third insulating layer and the fourth insulating layer,
wherein, optionally, the first electrode and the second electrode are disposed on the same layer as the gate,
wherein, optionally, each of the first electrode and the second electrode is connected to the semiconductor pattern through a contact hole defined by the second insulating layer, and,
wherein, optionally, the first electrode is connected to the light blocking pattern through a contact hole defined by the second insulating layer and the first insulating layer.

5. The display panel of claim 4, further comprising a pad connected to the pixel,
wherein the pad is disposed on the second insulating layer and exposed to the outside through a second contact hole defined in the third insulating layer and the fourth insulating layer, and,
wherein, optionally, the third insulating layer is in contact with a portion of the semiconductor pattern.

6. The display panel of claim 4, wherein the light emitting element includes an anode disposed on the fourth insulating layer, a cathode disposed on the anode, and a light emitting pattern disposed between the anode and the cathode, and
further comprising a pixel defining layer disposed on the fourth insulating layer and having an opening exposing at least a portion of the anode defined therein.

7. The display panel of any preceding claim, wherein the base layer further includes a sub-trench spaced apart from the trench and partially removed from the upper surface in the thickness direction,
wherein the pixel further includes second and third transistors each including a semiconductor pattern, a first electrode, a second electrode, and a gate, and
wherein one of the semiconductor pattern of the second transistor and the semiconductor pattern of the third transistor overlaps the sub-trench, and,
optionally, the display panel further comprises a sub-light blocking pattern at least partially overlapping the sub-trench and disposed on the base layer.

8. The display panel of any preceding claim, further comprising a first power line, a second power line, a scan line, a sensing line, and a data line connected to the pixel and disposed on the base layer,
wherein the first power line, the second power line, the scan line, the sensing line, and the data line are spaced apart from the trench, and
wherein, optionally, each of the first electrode, the second electrode, and the gate includes a lower layer including titanium, an intermediate layer including copper, and an upper layer including a transparent conductive oxide.

9. A display panel comprising:
a base layer including a first region partially removed from an upper surface in a thickness direction and a second region surrounding the first region;
a light blocking pattern at least partially overlapping the first region and disposed on the base layer; and
a pixel including first to third transistors each including a semiconductor pattern, a first electrode, a second electrode, and a gate, and a light emitting element connected to the first transistor,
wherein one of the semiconductor patterns overlaps the light blocking pattern and is disposed in the first region and a portion of the second region adjacent to the first region.

10. The display panel of claim 9, wherein a portion of the semiconductor pattern overlapping the light blocking pattern is parallel to a side surface of the base layer formed by removing a portion from the upper surface in a thickness direction.

11. The display panel of any of claims 1 to 8 or claim 10, wherein a width of the side surface in the thickness direction is 0.5 µm or more and 500 µm or less.

12. The display panel of any of claims 1 to 8, claim 10 or claim 11, wherein an angle between the upper surface and the side surface is greater than or equal to 90 degrees and less than or equal to 150 degrees.

13. A method of manufacturing a display panel, the method comprising:
forming a trench by removing a portion from an upper surface of a base layer in a thickness direction;
forming a light blocking pattern at least partially overlapping the trench and disposed on the base layer;
forming a first insulating layer on the base layer;
forming a semiconductor pattern at least partially overlapping the trench and disposed on the first insulating layer;
forming a second insulating layer in which first contact holes exposing a portion of the semiconductor pattern are defined;
forming a gate overlapping the semiconductor pattern and disposed on the second insulating layer; and
forming first and second electrodes insulated from the gate and connected to the semiconductor pattern through corresponding first contact holes.

14. The method of claim 13, wherein the trench is defined as a side surface connected to the upper surface and a bottom surface connected to the side surface and on which the light blocking pattern is disposed, and
wherein a portion of the semiconductor pattern is formed parallel to the side surface,
wherein, optionally, a width of the side surface in the thickness direction is 0.5 µm or more and 500 µm or less, and
wherein, optionally, an angle between the bottom surface and the side surface is greater than or equal to 90 degrees and less than or equal to 150 degrees.

15. The method of claim 13, further comprising:
forming a third insulating layer in which a second contact hole exposing a portion of the first electrode is defined, on the second insulating layer; and
forming a fourth insulating layer in which a third contact hole overlapping the second contact hole is defined, on the third insulating layer, and,
optionally, the method further comprises:
forming an anode connected to a portion of the first electrode through the second contact hole and the third contact hole;
forming a pixel defining layer having an opening exposing at least a portion of the anode, on the fourth insulating layer;
forming a light emitting pattern overlapping the opening; and
forming a cathode on the pixel defining layer, and
wherein, optionally, the first electrode, the second electrode, and the gate are formed of the same mask, and are disposed on the second insulating layer.
